# EUROPEAN PATENT APPLICATION

(11) **EP 4 842 160 A2**
(43) Date of publication of application: **18.11.2026**
(21) Application number: 26166323.1
(22) Date of filing: 20.03.2026
(51) Int. Cl.: H10D 30/67

(54) **THIN-FILM TRANSISTOR STRUCTURE AND ELECTRONIC PAPER DISPLAY**

(30) Priority: 02.05.2025 US 202563798579 P
(71) Applicant: E Ink Holdings Inc., 30078 Hsinchu (TW)
(72) Inventor: WU, Chi-Liang, HSINCHU (TW); CHEN, Wei-Tsung, HSINCHU (TW); KUO, Chia Hao, HSINCHU (TW); CHANG, Chun Kai, HSINCHU (TW)
(74) Representative: Winter, Brandl - Partnerschaft mbB

(57) **Abstract**

A thin-film transistor structure is provided. The thin-film transistor structure includes a gate electrode, an insulating layer, an active layer, and a source/drain layer. The insulating layer is disposed on the gate electrode, and the active layer is disposed on the insulating layer. The active layer includes several sub-regions, the sub-regions are mutually separated, and each of the sub-regions has a predetermined geometric shape in a top view and serves as a channel region. The source/drain layer is disposed on the active layer, and the source/drain layer corresponds to the sub-regions of the active layer to form corresponding electrode regions.

## Description

### BACKGROUND

### Technical field

The present disclosure relates to display technology, and more particularly to a thin-film transistor structure suitable for electronic paper displays (EPD).

### Description of Prior Art

In electronic paper displays, high-voltage driving methods are commonly employed to enhance the contrast of display pixels and improve display refresh rates. These methods incorporate gate driver on array (GoA) and multiplexer circuits, which reduce the number and cost of external integrated circuit (IC) drivers. However, the GoA and multiplexer circuits require large-sized thin-film transistors (TFTs) in order to drive the numerous gate lines and data lines, as well as to provide sufficient driving current. This allows the TFTs to withstand prolonged operation under high-voltage and high-current conditions.

Conventional thin-film transistors made from indium gallium zinc oxide (IGZO) materials usually have a bulk active layer design. In high-voltage or large-size applications, this design is susceptible to threshold voltage (Vth) drift and degradation of the driving current due to local thermal and bias stresses. This phenomenon causes the current-voltage characteristics of thin-film transistors (I_{D}-VG curve) to shift significantly after prolonged operation, resulting in problems such as an unstable display panel drive and inaccurate grayscale levels.

### SUMMARY

Accordingly, the present disclosure provides a thin-film transistor structure. The thin-film transistor structure includes a gate electrode, an insulating layer, an active layer, and a source/drain layer. The insulating layer is disposed on the gate electrode, and the active layer is disposed on the insulating layer. The active layer includes several sub-regions, the sub-regions are mutually separated, and each of the sub-regions has a predetermined geometric shape in a top view and serves as a channel region. The source/drain layer is disposed on the active layer, and the source/drain layer corresponds to the sub-regions of the active layer to form corresponding electrode regions.

According to one embodiment of the present disclosure, the predetermined geometric shape has a striped shape extending along a first direction, and the sub-regions are arranged along a second direction perpendicular to the first direction.

According to one embodiment of the present disclosure, the source/drain layer corresponds to the striped shape of each of the sub-regions and includes several striped electrodes. The striped electrodes extend along the second direction, causing the sub-regions and the source/drain layer to form a grid pattern in the top view.

According to one embodiment of the present disclosure, the predetermined geometric shape has a polygonal shape, and the polygonal shapes of the sub-regions are arranged in a matrix configuration.

According to one embodiment of the present disclosure, the source/drain layer includes a source electrode and a drain electrode spaced apart from each other. The source electrode and the drain electrode each include several finger-shaped electrode sections. The finger-shaped electrode sections correspond to and contact respective two terminals of the sub-regions, thereby positioning each of the sub-regions between the source electrode and the drain electrode.

According to one embodiment of the present disclosure, each of the sub-regions has a short side extending along a first direction and a long side extending along a second direction, in which the second direction is perpendicular to the first direction. Each of the finger-shaped electrode sections has a short side extending along the first direction and a long side extending along the second direction, in which the short side of each of the finger-shaped electrode sections is shorter than the short side of a corresponding one of the sub-regions.

According to one embodiment of the present disclosure, the gate electrode is configured to operate at a gate voltage amplitude greater than or equal to 60 volts, with a voltage value of the gate voltage amplitude ranging from greater than or equal to +30 volts to less than or equal to -30 volts.

According to one embodiment of the present disclosure, the active layer is an oxide semiconductor layer, and the oxide semiconductor layer comprises indium, gallium, and zinc.

The present disclosure provides an electronic paper display. The electronic paper display includes a display area and a gate driver circuit. The display area includes multiple pixel units. The gate driver circuit is electrically connected to the display area, in which the pixel units and the gate driver circuit each include multiple thin-film transistor structures, and the gate driver circuit sequentially activates the thin-film transistor structures row by row/column by column. Each of the thin-film transistor structures includes a gate electrode, an insulating layer, an active layer, and a source/drain layer. The insulating layer is disposed on the gate electrode, and the active layer is disposed on the insulating layer. The active layer includes several sub-regions, the sub-regions are mutually separated, and each of the sub-regions has a predetermined geometric shape in a top view and serves as a channel region. The source/drain layer is disposed on the active layer, and the source/drain layer corresponds to the sub-regions of the active layer to form corresponding electrode regions.

According to one embodiment of the present disclosure, the electronic paper display further includes a multiplexer circuit. The multiplexer circuit is electrically connected to the display area and includes multiple second thin-film transistor structures. The second thin-film transistor structures are identical to the thin-film transistor structures within the gate driver circuit and the display area.

According to one embodiment of the present disclosure, the predetermined geometric shape has a striped shape extending along a first direction, and the sub-regions are arranged along a second direction perpendicular to the first direction.

According to one embodiment of the present disclosure, the source/drain layer corresponds to the striped shape of each of the sub-regions and includes several striped electrodes. The striped electrodes extend along the second direction, causing the sub-regions and the source/drain layer to form a grid pattern in the top view.

According to one embodiment of the present disclosure, the predetermined geometric shape has a polygonal shape, and the polygonal shapes of the sub-regions are arranged in a matrix configuration.

According to one embodiment of the present disclosure, the source/drain layer includes a source electrode and a drain electrode spaced apart from each other. The source electrode and the drain electrode each include several finger-shaped electrode sections. The finger-shaped electrode sections correspond to and contact respective two terminals of the sub-regions, thereby positioning each of the sub-regions between the source electrode and the drain electrode.

According to one embodiment of the present disclosure, each of the sub-regions has a short side extending along a first direction and a long side extending along a second direction, in which the second direction is perpendicular to the first direction. Each of the finger-shaped electrode sections has a short side extending along the first direction and a long side extending along the second direction, in which the short side of each of the finger-shaped electrode sections is shorter than the short side of a corresponding one of the sub-regions.

According to one embodiment of the present disclosure, the gate electrode is configured to operate at a gate voltage amplitude greater than or equal to 60 volts, with a voltage value of the gate voltage amplitude ranging from greater than or equal to +30 volts to less than or equal to -30 volts.

According to one embodiment of the present disclosure, the active layer is an oxide semiconductor layer, and the oxide semiconductor layer comprises indium, gallium, and zinc.

### BRIEF DESCRIPTION OF THE DRAWINGS

For a clearer and easier understanding of the above and other objects, features, advantages, and embodiments of the present disclosure, the drawings are described below.
FIG. 1 is a schematic diagram of an electronic paper display according to an embodiment of the present disclosure.
FIG. 2 is a schematic diagram of predetermined geometric shapes of an active layer in a top view according to a first embodiment of the present disclosure.
FIG. 3 is a schematic diagram of a relative positional relationship between the active layer and a source/drain layer in the top view according to the first embodiment of the present disclosure.
FIG. 4 is a schematic diagram of predetermined geometric shapes of an active layer in the top view according to a second embodiment of the present disclosure.
FIG. 5 is a schematic diagram of a relative positional relationship between the active layer and a source/drain layer in the top view according to the second embodiment of the present disclosure.
FIG. 6 is an enlarged schematic in the top view of a gate electrode, the active layer, and the source/drain layer depicted within the dashed line box in FIG. 5.

### DETAILED DESCRIPTION

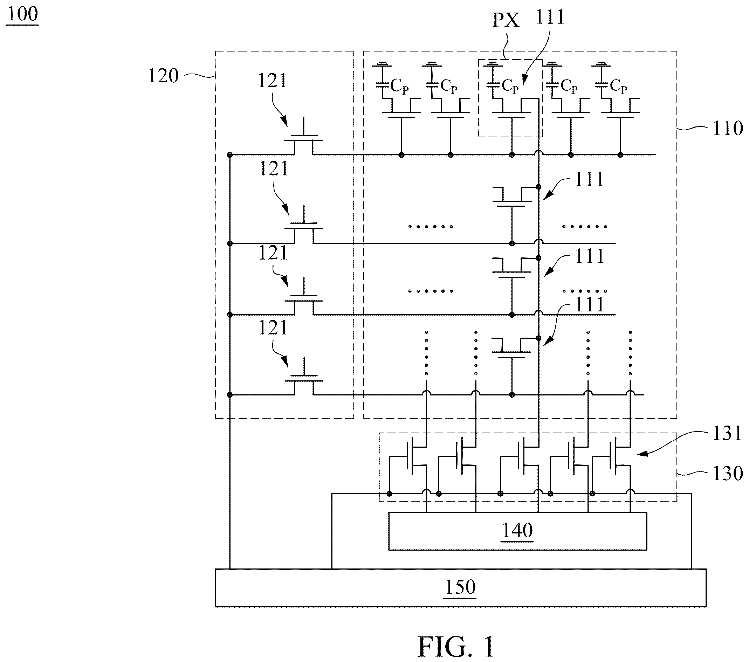

Referring to FIG. 1, FIG. 1 is a schematic diagram of an electronic paper display 100 according to an embodiment of the present disclosure. The electronic paper display 100 includes a display area 110, a gate driver circuit 120, a multiplexer circuit 130, a source driver circuit 140, and a flexible printed circuit (FPC) board 150.

The display area 110 includes multiple pixel units PX. These pixel units PX are disposed on an insulating substrate (e.g., a glass substrate) and arranged in a matrix to form a number of rows and columns of the display area 110. Each pixel unit PX includes at least one thin-film transistor 111 and a pixel capacitor C_{P}. The thin-film transistor 111 is used to control the potential difference between the pixel electrode and the common electrode to drive the display state of the electronic paper display layer (e.g., an electrophoretic layer or a microcapsule layer) according to the charge change of the pixel capacitor C_{P}.

The gate driver circuit 120 is coupled to the display area 110 and includes multiple thin-film transistors 121. When the thin-film transistors 121 are sequentially turned on, the gate driver circuit 120 sequentially outputs gate scanning signals to gate lines connected to corresponding row/columns of the display area 110, causing the thin-film transistors 111 within the pixel units PX of the corresponding row/columns to turn on. In the disclosed embodiments, the gate driver circuit 120 is a gate driver on array (GoA), which may be formed on the same substrate as the display area 110 and may adopt the same layered structure as the display area 110 to facilitate process integration.

The multiplexer circuit 130 also includes multiple thin-film transistors 131 for switching different data lines, gate lines, or control signals to time-divide the selection of display refresh areas. The source driver circuit 140 generates corresponding data voltages based on external image data and outputs them to the data lines of the display area 110. Then, these data voltages are written into the pixel units PX within the columns/rows via transmission through the data lines.

The thin-film transistors 111, 121, and 131 in the display area 110, gate driver circuit 120, and multiplexer circuit 130, respectively, may all adopt the thin-film transistor structure disclosed herein. In the disclosed embodiments, the active layers of the thin-film transistors 111, 121, and 131 each include an oxide semiconductor layer made of indium gallium zinc oxide (IGZO) material, which exhibits high electron mobility, low leakage current, and high uniformity simultaneously. In the disclosed embodiments, the thin-film transistors 111, 121, 131 each have a structure consisting of a gate electrode, an insulating layer, an active layer, a source/drain layer, and a protective layer stacked sequentially. The indium gallium zinc oxide in the active layer serves as an electron conduction channel that conducts when a gate voltage is applied to the gate electrode.

The flexible printed circuit board 150 may be configured along the edge or periphery of the display area 110, connecting the input terminals of various driver circuits and peripheral circuits around the display area 110. This allows the external control integrated circuits to transmit timing control signals, data signals, and power signals through the flexible printed circuit board 150.

In the disclosed embodiments, the active layers of thin-film transistors 111, 121, and 131 are positioned between their gate electrodes and source/drain layers. Each active layer includes multiple sub-regions with predetermined geometric shapes that are separated from one another. The following describes the embodiments of the disclosure regarding the predetermined geometric shapes of the sub-regions of the active layer and its corresponding source/drain layer structure, as well as the relative arrangement of the two.

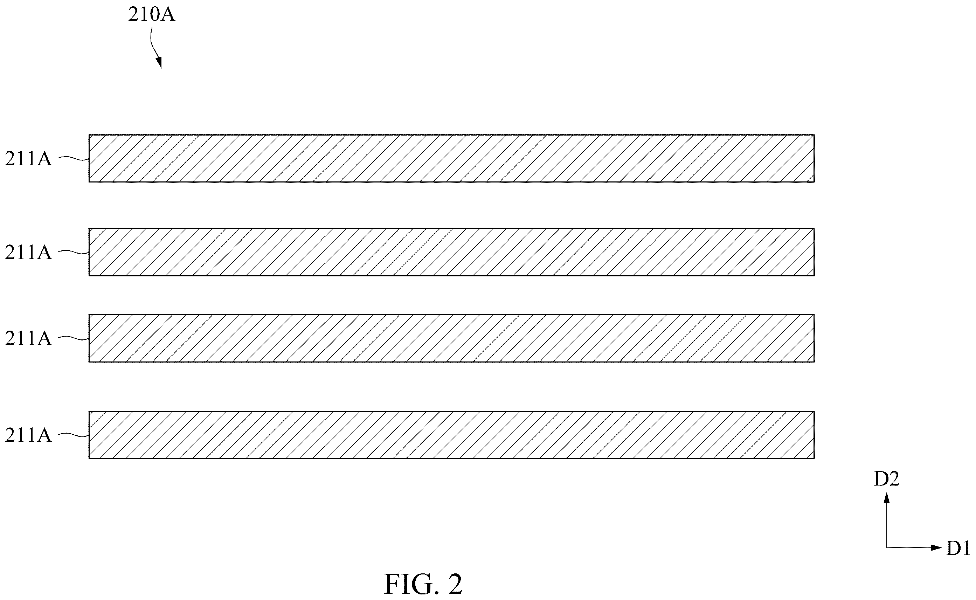

Referring to FIG. 2, FIG. 2 is a schematic diagram of predetermined geometric shapes of an active layer 210A in a top view according to a first embodiment of the present disclosure. The active layer 210A includes several sub-regions 211A that are mutually separated. Each sub-region 211A forms a striped shape extending along the first direction D1 in the top view, and these sub-regions 211A are arranged along the second direction D2 perpendicular to the first direction D1.

Dividing the active layer 210A into several isolated sub-regions 211A effectively reduces the local thermal build-up caused by current concentration and mitigates the effects of thermal stress induced by prolonged high-voltage operation. Furthermore, effectively mitigating the effects of thermal stress reduces the amount by which the threshold voltages of the thin-film transistors 111, 121, and 131 drift as the gate voltage increase. This allows the driving currents of the thin-film transistors 111, 121, and 131 at each operating point to approach their original desired values.

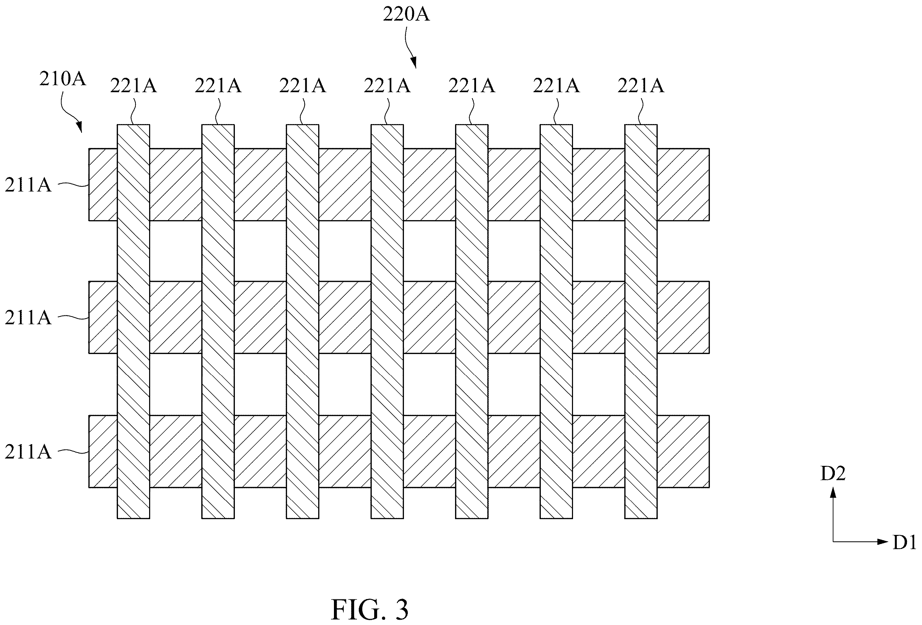

Referring to FIG. 3, FIG. 3 is a schematic diagram of a relative positional relationship between the active layer 210A and a source/drain layer 220A in the top view according to the first embodiment of the present disclosure. The source/drain layer 220A corresponds to the strip-shaped sub-regions 211A of the active layer 210A as striped electrodes 221A. These striped electrodes 221A extend along the second direction D2 and are arranged in an intermittent manner along the first direction D1 above the active layer 210A. As shown in the top view of FIG. 3, these strip-shaped sub-regions 211A are arranged in a grid pattern with the striped electrodes 221A of the source/drain layer 220A.

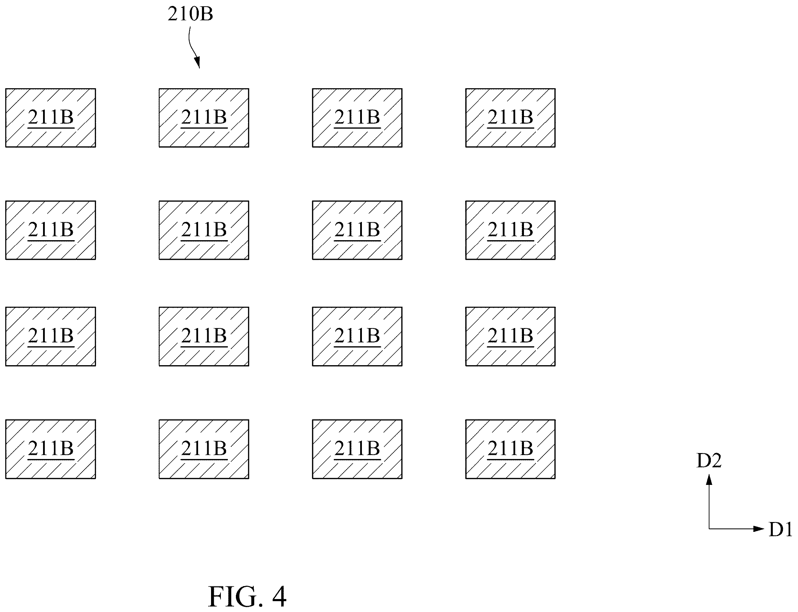

Referring to FIG. 4, FIG. 4 is a schematic diagram of predetermined geometric shapes of an active layer 210B in the top view according to a second embodiment of the present disclosure. The active layer 210B includes several sub-regions 211B that are mutually separated. Each sub-region 211B is configured with a predetermined geometric shape of a polygonal shape in the top view, and these sub-regions 211B are arranged in a matrix configuration. The polygonal shape of sub-region 211 B may be, for example, a rectangle, a square, or other symmetrical shape.

Dividing the active layer 210B into several isolated sub-regions 211B effectively reduces the local thermal build-up caused by current concentration and mitigates the effects of thermal stress induced by prolonged high-voltage operation. Furthermore, effectively mitigating the effects of thermal stress reduces the amount by which the threshold voltages of the thin-film transistors 111, 121, and 131 drift as the gate voltage increase. This allows the driving currents of the thin-film transistors 111, 121, and 131 at each operating point to approach their original desired values.

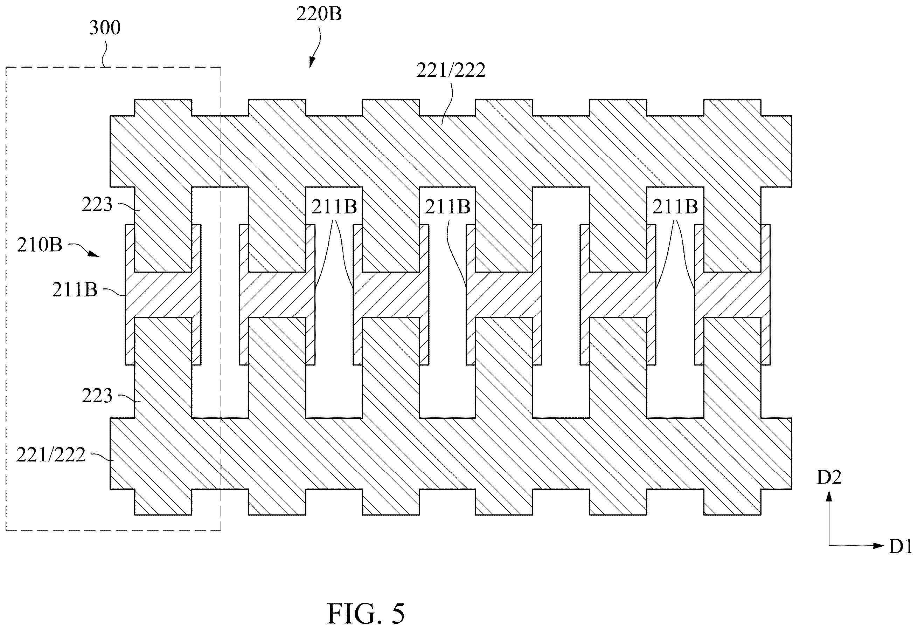

Referring to FIG. 5, FIG. 5 is a schematic diagram of a relative positional relationship between the active layer 210B and a source/drain layer 220B in the top view according to the second embodiment of the present disclosure. The source/drain layer 220B includes a source electrode 221 and a drain electrode 222 spaced apart from each other. The source electrode 221 and the drain electrode 222 each include multiple finger-shaped electrode sections 223. These finger-shaped electrode sections 223 are paired correspondingly and contact the respective two terminals of the underlying sub-region 211B, positioning each sub-region 211B between the source electrode 221 and the drain electrode 222.

This multi-finger electrode structure creates multiple independent current channels within the same area, reducing the current load on each channel. This prevents excessive current density or heat build-up in a single pathway.

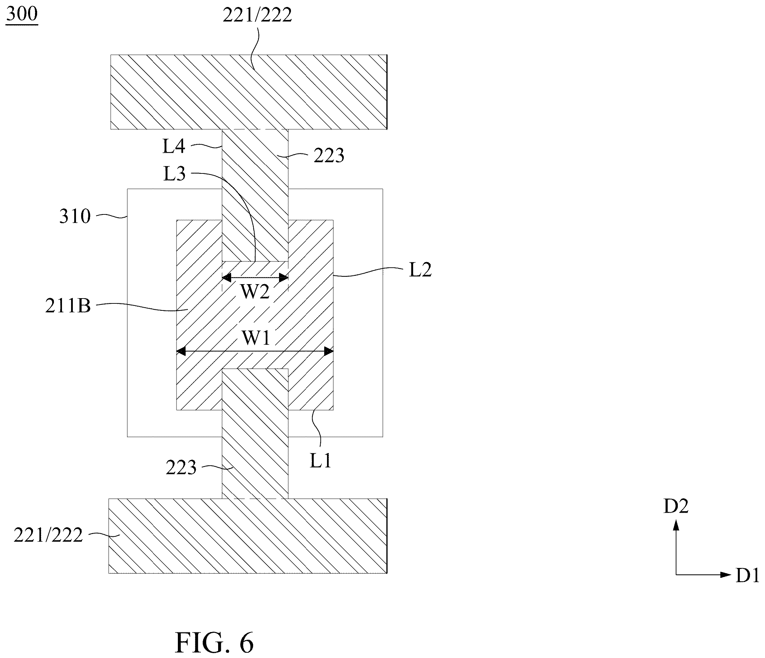

Referring to FIG. 6, FIG. 6 is an enlarged schematic in the top view of a gate electrode 310, the active layer 210B, and the source/drain layer 220B depicted within the dashed-line box of FIG. 5. The sub-region 211B of the active layer 210B has a short side L1 extending along the first direction D1 and a long side L2 extending along the second direction D2. The finger-shaped electrode section 223 has a short side L3 extending along the first direction D1 and a long side L4 extending along the second direction D2. The short sides L3 of these finger-shaped electrode sections 223 are each smaller than the short side L1 of the sub-region 211B, meaning the width W2 is smaller than the width W1.

Designing width W2 to be smaller than width W1 reduces the overlap area between the source electrode 221/drain electrode 222 and the sub-region 211B, thereby decreasing the parasitic capacitance between the gate electrode 310 and the source electrode 221/drain electrode 222.

Using the strip-shaped active layer 210A of the first embodiment or the matrix-arranged active layer 210B of the second embodiment enables the thin-film transistors 111, 121, and 131 within the electronic paper display 100 to maintain stable driving currents and linear output characteristics under high driving voltages and in large-area panel applications. The term "high drive voltage" refers to a gate voltage value greater than or equal to +30 volts to -30 volts (i.e., the gate voltage value≥ (-30V)~(+30V)), enabling the gate voltage amplitude of 60 volts or higher to be applied.

Whether in the first embodiment or the second embodiment, the number of sub-regions within the active layers 210A and 210B may be adjusted according to actual application requirements. For example, driver circuits that require a high current output may have an increased number of sub-regions to enhance the total channel width. In low power applications, the number of sub-regions may be reduced to simplify routing and lower process complexity. Additionally, the configuration density and spacing of sub-regions may also be adjusted based on layout area, line loading, and driving voltage conditions.

In summary, the disclosed electronic paper display and the thin-film transistor structure thereof effectively distribute current density and thermal stress. This is achieved by dividing the active layer into multiple isolated sub-regions and by designing strip-shaped or finger-shaped source/drain electrodes. Furthermore, this design suppresses threshold voltage drift and current decay during prolonged high-voltage operation, enabling the thin-film transistors to maintain stable driving capability and reliability under operating conditions such as high voltage, large dimensions, and long-term bias stress. Consequently, stable display quality is ensured for electronic paper display panels during high contrast and high speed refresh operations.

## Claims

1. A thin-film transistor (111, 121, 131) structure **characterized by** comprising:
a gate electrode (310);
an insulating layer disposed on the gate electrode (310);
an active layer (210A, 210B) disposed on the insulating layer and comprising a plurality of sub-regions (211A, 211B), wherein the sub-regions (211A, 211B) are mutually separated, and each of the sub-regions (211A, 211B) has a predetermined geometric shape in a top view and serves as a channel region; and
a source/drain layer (220A, 220B) disposed on the active layer (210A, 210B), wherein the source/drain layer (220A, 220B) corresponds to the sub-regions (210A, 210B) of the active layer (210A, 210B) to form corresponding electrode regions.

2. The thin-film transistor (111, 121, 131) structure of claim 1, **characterized in that** the predetermined geometric shape has a striped shape extending along a first direction (D1), and the sub-regions (210A) are arranged along a second direction (D2) perpendicular to the first direction (D1).

3. The thin-film transistor (111, 121, 131) structure of claim 2, **characterized in that** the source/drain layer (220A) corresponds to the striped shape of each of the sub-regions (210A) and includes a plurality of striped electrodes (221A), and wherein the striped electrodes (221A) extend along the second direction (D2), causing the sub-regions (210A) and the source/drain layer (220A) to form a grid pattern in the top view.

4. The thin-film transistor (111, 121, 131) structure of claim 1, **characterized in that** the predetermined geometric shape has a polygonal shape, and the polygonal shapes of the sub-regions (211B) are arranged in a matrix configuration.

5. The thin-film transistor (111, 121, 131) structure of claim 4, **characterized in that** the source/drain layer (220B) comprises a source electrode (221) and a drain electrode (222) spaced apart from each other, the source electrode (221) and the drain electrode (222) each comprise a plurality of finger-shaped electrode sections (223), and the finger-shaped electrode sections (223) correspond to and contact respective two terminals of the sub-regions (211B), thereby positioning each of the sub-regions (211B) between the source electrode (221) and the drain electrode (222).

6. The thin-film transistor (111, 121, 131) structure of claim 5, **characterized in that**:
each of the sub-regions (211B) has a short side (L1) extending along a first direction (D1) and a long side (L2) extending along a second direction (D2), and wherein the second direction (D2) is perpendicular to the first direction (D1); and
each of the finger-shaped electrode sections (223) has a short side (L3) extending along the first direction (D1) and a long side (L4) extending along the second direction (D2), and wherein the short side (L3) of each of the finger-shaped electrode sections (223) is shorter than the short side (L1) of a corresponding one of the sub-regions (211B).

7. The thin-film transistor (111, 121, 131) structure of any of claims 1 to 6, **characterized in that** the gate electrode (310) is configured to operate at a gate voltage amplitude greater than or equal to 60 volts, with a voltage value of the gate voltage amplitude ranging from greater than or equal to +30 volts to less than or equal to -30 volts.

8. The thin-film transistor (111, 121, 131) structure of any of claims 1 to 7, **characterized in that** the active layer (210A, 210B) is an oxide semiconductor layer, and the oxide semiconductor layer comprises indium, gallium, and zinc.

9. An electronic paper display (100) **characterized by** comprising:
a display area (110) comprising a plurality of pixel units (PX); and
a gate driver circuit (120) electrically connected to the display area, wherein the pixel units (PX) and the gate driver circuit (120) each comprise a plurality of thin-film transistor (111, 121) structures, and the gate driver circuit (120) sequentially activates the thin-film transistor (111, 121) structures row by row/column by column, and wherein each of the thin-film transistor (111, 121) structures comprises:
a gate electrode (310);
an insulating layer disposed on the gate electrode (310);
an active layer (210A, 210B) disposed on the insulating layer and comprising a plurality of sub-regions (211A, 211B), wherein the sub-regions (211A, 211B) are mutually separated, and each of the sub-regions (211A, 211B) has a predetermined geometric shape in a top view and serves as a channel region; and
a source/drain layer (220A, 220B) disposed on the active layer (210A, 210B), wherein the source/drain layer (220A, 220B) corresponds to the sub-regions (210A, 210B) of the active layer (210A, 210B) to form corresponding electrode regions.

10. The electronic paper display (100) of claim 9, **characterized by** further comprising:
a multiplexer circuit (130) electrically connected to the display area (110) and comprising a plurality of second thin-film transistor (131) structures, wherein the second thin-film transistor (131) structures are identical to the thin-film transistor (111, 121) structures within the gate driver circuit (120) and the display area (110).

11. The electronic paper display (100) of claim 9, **characterized in that** the predetermined geometric shape has a striped shape extending along a first direction (D1), and the sub-regions (210A) are arranged along a second direction (D2) perpendicular to the first direction (D1).

12. The electronic paper display (100) of claim 11, **characterized in that** the source/drain layer (220A) corresponds to the striped shape of each of the sub-regions (210A) and includes a plurality of striped electrodes (221A), and wherein the striped electrodes (221A) extend along the second direction (D2), causing the sub-regions (210A) and the source/drain layer (220A) to form a grid pattern in the top view.

13. The electronic paper display (100) of claim 9, **characterized in that** the predetermined geometric shape has a polygonal shape, and the polygonal shapes of the sub-regions (211B) are arranged in a matrix configuration.

14. The electronic paper display (100) of claim 13, **characterized in that** the source/drain layer (220B) comprises a source electrode (221) and a drain electrode (222) spaced apart from each other, the source electrode (221) and the drain electrode (222) each comprise a plurality of finger-shaped electrode sections (223), and the finger-shaped electrode sections (223) correspond to and contact respective two terminals of the sub-regions (211B), thereby positioning each of the sub-regions (211B) between the source electrode (221) and the drain electrode (222).

15. The electronic paper display (100) of claim 14, **characterized in that**:
each of the sub-regions (211B) has a short side (L1) extending along a first direction (D1) and a long side (L2) extending along a second direction (D2), and wherein the second direction (D2) is perpendicular to the first direction (D1); and
each of the finger-shaped electrode sections (223) has a short side (L3) extending along the first direction (D1) and a long side (L4) extending along the second direction (D2), and wherein the short side (L3) of each of the finger-shaped electrode sections (223) is shorter than the short side (L1) of a corresponding one of the sub-regions (211B).
